# EUROPEAN PATENT APPLICATION

(11) **EP 4 768 971 A1**
(43) Date of publication of application: **01.07.2026**
(21) Application number: 24935258.4
(22) Date of filing: 27.11.2024
(51) Int. Cl.: G01R 31/396, G01R 31/382, G01R 31/36, G01R 31/367, G01R 31/374, G01R 19/165

(54) **DATA ANALYSIS DEVICE AND METHOD**

(30) Priority: 12.04.2024 KR 20240049482
(71) Applicant: LG Energy Solution, Ltd., Seoul 07335 (KR)
(72) Inventor: CHOI, Yo Hwan, Daejeon 34122 (KR)
(74) Representative: Plasseraud IP
(86) International application number: PCT/KR2024/018994
(87) International publication number: WO 2025/216385

(57) **Abstract**

According to an embodiment disclosed herein, a data analysis device may include an interface unit configured to acquire capacity data and voltage data of a battery provided in an electronic device, and one or more processors configured to preprocess the capacity data and the voltage data to calculate differential capacity data, and extract at least one feature for diagnosing the battery based on a value of the differential capacity data in at least one voltage band set based on characteristics of at least one of the battery and the electronic device.

## Description

### TECHNICAL FIELD

### CROSS-REFERENCE TO RELATED APPLICATION

This application claims priority to and the benefit of Korean Patent Application No. 10-2024-0049482 filed in the Korean Intellectual Property Office on April 12, 2024, the entire contents of which are incorporated herein by reference.

### TECHNICAL FIELD

Embodiments disclosed herein relate to a data analysis device and method.

### BACKGROUND ART

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, the lithium-ion batteries have an advantage of having a much higher energy density than the conventional Ni/Cd batteries, the Ni/MH batteries, and the like. In addition, since the small and light-weight lithium ion batteries may be manufactured, the lithium ion batteries are used as a power source for mobile devices, and recently, the lithium ion batteries are attracting attention as a next-generation energy storage medium due to the expansion of the range of use to a power source for electric vehicles.

In addition, the secondary batteries may generally be used as a battery pack including a battery module in which a plurality of battery cells are connected in series and/or in parallel. In addition, the secondary batteries may be used as a battery rack including a plurality of battery modules and a rack frame accommodating the battery modules.

The battery cells, the battery modules, the battery packs, or the battery racks may be used in various devices. For example, the batteries may be used not only in mobile devices such as mobile phones, laptop computers, smart phones, and smart pads, but also in a field such as vehicles (electric vehicles (EV), hybrid electric vehicles (HEV), and plug-in HEVs (PHEV)) driven by electricity or a large power storage device (electric power storage system (ESS)).

States and operations of the batteries may be managed and controlled by a battery management system (BMS). The BMS may be included in one device together with the battery.

In addition, the BMS may manage and control the battery in a state of being spaced apart from the device including the battery. For example, the BMS may be implemented as a separate server device. In this case, the BMS may collect battery data and vehicle data from a vehicle and the like and manage and control the battery using the collected data.

Meanwhile, when a defective battery is present, the possibility of damage to devices (e.g., an EV, an ESS, and the like) including the corresponding battery may increase. Accordingly, there is a need for a method for detecting an abnormal state of the battery to reducing the possibility of damage to devices including a battery.

### DISCLOSURE

### TECHNICAL PROBLEM

In general, indicators for battery safety diagnosis are extracted from data having a repeated pattern in a constant environment (e.g., an experimental environment). However, since field data acquired from a battery in use does not have a repeated pattern, it is necessary to develop a technology of extracting indicators for battery diagnosis from the field data.

Embodiments disclosed herein are directed to providing a data analysis device and method, which are capable of preprocessing field data to stably extract features for diagnosing a battery.

The technical objects of the embodiments disclosed herein are not limited to the above-described technical objects, and other objects that are not described will be able to be clearly understood by those skilled in the art from the following descriptions.

### TECHNICAL SOLUTION

According to an embodiment disclosed herein, a data analysis device may include an interface unit configured to acquire capacity data and voltage data of a battery provided in an electronic device, and one or more processors configured to preprocess the capacity data and the voltage data to calculate differential capacity data, and extract at least one feature for diagnosing the battery based on a value of the differential capacity data in at least one voltage band set based on characteristics of at least one of the battery and the electronic device.

According to an embodiment, the one or more processors may be configured to extract the capacity data and the voltage data in a target section, convert the capacity data and the voltage data so that the extracted voltage data is capable of being differentiated in the target section, and interpolate the converted capacity data and voltage data to calculate the differential capacity data.

According to an embodiment, the one or more processors may be configured to identify the target section corresponding to a slow charging section during charging of the battery to extract the capacity data and the voltage data.

According to an embodiment, the one or more processors may be configured to classify multiple capacity data having the same voltage value among the extracted voltage data, and calculate an average value of the multiple capacity data having the same voltage value and convert the average value into a capacity value corresponding to the voltage value.

According to an embodiment, the one or more processors may be configured to interpolate the converted capacity data and voltage data using a piecewise cubic Hermite interpolating polynomial (PCHIP) method to convert a voltage of the battery to monotonically increase or monotonically decrease.

According to an embodiment, the one or more processors may be configured to perform Gaussian filtering on the differential capacity data with a preset window size to smooth the differential capacity data.

According to an embodiment, when an inflection point of the differential capacity data is present in each voltage band, the one or more processors may be configured to extract at least one of a minimum value and a maximum value of the differential capacity data in the voltage band as the feature.

According to an embodiment, the one or more processors may be configured to perform diagnosis on the battery based on a value of differential capacity data corresponding to the feature.

According to an embodiment, the one or more processors may be configured to match characteristics corresponding the extracted features with characteristics of the battery to build a database.

According to an embodiment disclosed herein, a data analysis method may include acquiring capacity data and voltage data of a battery provided in an electronic device, preprocessing the capacity data and the voltage data to calculate differential capacity data, and extracting at least one feature for diagnosing the battery based on a value of the differential capacity data in at least one voltage band set based on characteristics of at least one of the battery and the electronic device.

According to an embodiment, the calculating of the differential capacity data may include extracting the capacity data and the voltage data in a target section, converting the capacity data and the voltage data so that the extracted voltage data is capable of being differentiated in the target section, and interpolating the converted capacity data and voltage data to calculate the differential capacity data.

According to an embodiment, when an inflection point of the differential capacity data is present in each voltage band, the extracting of the at least one feature may include extracting at least one of a minimum value and a maximum value of the differential capacity data as the feature.

According to an embodiment, the data analysis method may further include performing diagnosis on the battery based on a change in differential capacity value corresponding to the feature.

### ADVANTAGEOUS EFFECTS

The data analysis device and method according to the embodiments disclosed herein can preprocessing the field data of the battery to calculate differential capacity data, thereby stably and accurately extracting features for diagnosing a battery from differential capacity data.

In addition, various effects that may be directly or indirectly identified through the present document can be provided.

### DESCRIPTION OF DRAWINGS

FIG. 1 is a block diagram illustrating a configuration of a data analysis device according to one embodiment disclosed herein.
FIG. 2 is a view illustrating an example of battery data and differential data according to one embodiment disclosed herein.
FIG. 3 is a view illustrating a preprocessing process of the battery data according to one embodiment disclosed herein.
FIG. 4 is a view illustrating an example of feature extraction according to one embodiment disclosed herein.
FIG. 5 is a view illustrating an example of information stored in a database according to one embodiment disclosed herein.
FIG. 6 is a flowchart for describing a data analysis method according to one embodiment disclosed herein.
FIG. 7 is a flowchart for describing the data analysis method according to one embodiment disclosed herein.
FIG. 8 is a block diagram showing a hardware configuration of a computing system for performing a method of operating a data analysis device according to one embodiment disclosed herein.

### MODE FOR INVENTION

Hereinafter, various embodiments of the present disclosure will be described with reference to the accompanying drawings. However, it should be understood that this is not intended to limit the present disclosure to specific embodiments and includes various modifications, equivalents, and/or alternatives of the embodiments of the present disclosure.

The singular form of a noun corresponding to an item in this document may include one item or a plurality of items unless the relevant context clearly dictates otherwise. In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," or "second" may simply be used to distinguish the corresponding component from another and do not limit the corresponding components in another aspect (e.g., importance or order). When a certain (e.g., a first) component is described as being "connected," "coupled," or "joined or "coupled" or "connected" to another (e.g., a second) component with or without the terms "functionally" or "communicatively," this means that the certain component may be connected to another component directly (e.g., in a wired manner), in a wireless manner, or through a third component.

Each (e.g., a module or a program) of components described herein may include a single object or a plurality of objects. According to various embodiments, one or more among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to various embodiments, operations performed by modules, programs, or other components may be executed sequentially, in parallel, repeatedly, or heuristically, or one or more of the operations may be executed in a different order or omitted, or one or more other operations may be added.

As used herein, the term "module," or "part" may include a unit implemented in hardware, software, or firmware and may be used interchangeably with terms such as logic, logic block, component, or circuit. The module may be an integrated part or a minimum unit of the parts or a portion thereof that performs one or more functions. For example, according to one embodiment, the module may be implemented in the form of an application-specific integrated circuit (ASIC).

Various embodiments of this document may be implemented as software (e.g., a program or application) including one or more commands stored in a storage medium (e.g., a memory) that may be read by a machine. For example, a processor of the device may fetch at least one command among one or more commands stored from a storage medium and execute the commands. This allows the device to be operated to perform at least one function according to the at least one fetched command. The one or more commands may include code generated by a compiler or code that may be executed by an interpreter. A device-readable storage medium may be provided in the form of a non-transitory storage medium. Here, "non-transitory storage medium" is a tangible device and only means not including a signal (e.g., electromagnetic waves), and this term does not distinguish between cases in which data is stored semi-permanently and temporarily in the storage medium.

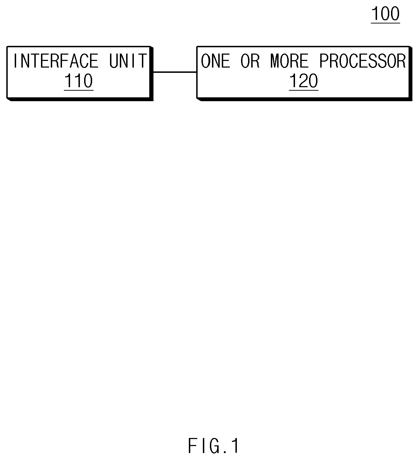

FIG. 1 is a block diagram illustrating a configuration of a data analysis device according to one embodiment disclosed herein.

Referring to FIG. 1, a battery analysis device 100 may include an interface unit 110 and one or more processors 120.

The data analysis device 100 may acquire field data on a battery provided in an electronic device and extract features for diagnosing the battery from the field data. In one embodiment, the electronic device 100 may be a mobile device (e.g., a mobile phone, a laptop computers, a smart phone, or a smart pad), an electric vehicle (e.g., an electric vehicle (EV), a hybrid EV (HEV), a plug-in HEV (PHEV), or a fuel cell EV (FCEV)), an energy storage system (ESS), or a battery swapping system (BSS).

The following operation of the data analysis device 100 may be performed by a battery management system (BMS) in the vehicle and a battery BMS provided in a battery pack and may also be performed in various devices such as a server, a cloud, a charger, a charger/discharger, and the like.

The interface unit 110 may establish connection between the data analysis device 100 and an external component (e.g., an electronic device, a BMS of a battery pack, a sensor, a vehicle BMS, or the like) and transmit and receive data through the established connection. The connection between the interface unit 110 and the external component may be communication connection through a wired and/or wireless network. In one embodiment, the wired network may be based on local area network (LAN) communication or powerline communication. In one embodiment, the wireless network may be based on a short-range communication network (e.g., Bluetooth, WiFi, or IrDA) or a telecommunication network (a cellular network, a 4G network, or a 5G network).

According to another embodiment, the connection between the battery analysis device 100 and the electronic device may be connection through an inter-device communication method (e.g., a bus, a general purpose input and output (GPIO), a serial peripheral interface (SPI), or a mobile industry processor interface (MIPI)).

The interface unit 110 may acquire information about a battery provided in the electronic device. The battery may be a battery module, a battery pack, or a battery bank and may be each battery cell included in each battery module, pack, or bank.

In one embodiment, when the data analysis device 100 is implemented as a component (e.g., an external server of the electronic device) separately from the electronic device, the interface unit 110 may acquire information about the battery through a communication channel established between the data analysis device 100 and the electronic device.

In another embodiment, when the data analysis device 100 is implemented as a BMS in the electronic device, the interface unit 110 may acquire information about the battery from at least one sensor capable of measuring information about a state (e.g., a voltage, a current, a temperature, or the like) of the battery.

The interface unit 110 may acquire data on the capacity and voltage of the battery provided in the electronic device. The data on the capacity and voltage of the battery acquired by the interface unit 110 may be time series data for time.

In addition to the capacity and voltage of the battery, the interface unit 110 may acquire additional information about the battery, such as a temperature and a state of health (SoH).

The processor 120 may be implemented as one or more processors. Each of the processors may include a central processing unit, an application processor, a graphics processing unit, a neural processing unit (NPU), an image signal processor, a sensor hub processor, or a communication processor.

Functions and operations of the data analysis device 100, which will be described below, may be performed by one processor, or the functions may be at least partially separated and performed by a plurality of processors. Hereinafter, for convenience of description, a case in which the operation of the battery diagnosis device 100 is performed by one processor will be described.

The processor 120 may extract features for diagnosing the battery from the capacity and voltage data of the battery acquired by the interface unit 110. For example, the processor 120 may derive differential capacity data from the capacity and voltage data of the battery and analyze the differential capacity data to extract at least one feature.

The processor 120 may use the capacity and voltage data acquired at a specific time section depending on the characteristics of an indicator to be extracted, the purpose of battery diagnosis (e.g., deterioration diagnosis), or the like. For example, the processor 120 may use the capacity data and voltage data acquired during a charging process of the battery.

The processor 120 may preprocess the capacity and voltage data to calculate differential capacity data. The processor 120 may convert the capacity data and voltage data acquired from the interface unit 110 into differential capacity data in order to extract indicators for diagnosing the battery from the field data.

According to an embodiment, the processor 120 may extract the capacity data and the voltage data in a target section. In the case of the field data, data may be inaccurate due to various variables, such as noise, duplicate data due to sensor errors, or the like, depending on a charging section and charging conditions of a battery, an environment of an electronic device, or the like.

Accordingly, the processor 120 may extract and use data in the target section among the capacity data and voltage data acquired from the interface unit 110. That is, the processor 120 may set a target section and use capacity data and voltage data included in the target section for analysis so that robust data analysis may be applied to batteries in various environments.

In one embodiment, the target section corresponding to a slow charging section during charging of the battery may be identified to extract capacity data and voltage data. That is, the processor 120 may define the slow charging section during the charging process of the battery and set the slow charging section to the target section.

For example, since voltage data and capacity data may be distorted due to a temporary decrease in voltage due to a chemical reaction inside the battery during a rest section after the battery is completely charged, the processor 120 may extract voltage data and capacity data in a preset target section.

In one embodiment, the slow charging section may be defined as a charging section in which voltage and capacity change stably during the charging process of the battery. For example, the slow charging section may be defined as a section from a time point at which a preset period elapses from a charging start time point of the battery to a specified time before charging is ended. As another example, the slow charging section may be set to a section in which a voltage of the battery ranges from 2.8 V to 4.2 V.

According to an embodiment, the processor 120 may convert the capacity data and the voltage data so that the extracted voltage data may be differentiated in the target section. As described above, since the field data is acquired under different environmental and operating conditions and noise and outliers may be included in the acquired data, preprocessing of the acquired data is required to extract robust and accurate features.

For example, the field data acquired from the interface unit 110 may include noise, distorted data, or duplicate voltage signals due to errors of a sensor, and in this case, analysis may be difficult, such as when differential capacity data cannot be calculated. Accordingly, the processor 120 may convert the capacity data and the voltage data so that the voltage data may be differentiated in the target section.

In one embodiment, the processor 120 may classify the capacity data having the same voltage value among the extracted voltage data. As described above, the field data may include duplicate voltage data, and in this case, differentiation is not possible (differentiation value diverges), and thus differential capacity data may be calculated. Accordingly, the processor 120 may classify the capacity data and the voltage data according to the magnitude of the voltage to classify the multiple capacity data having the same voltage value.

The processor 120 may calculate an average value of the multiple capacity data having the same voltage value and convert the average value into a capacity value corresponding to the voltage value. This is only illustrative, and it is apparent that converting into a modal value, a minimum value, maximum value, or a value calculated through other mathematical calculations in addition to the average value is possible.

Accordingly, the processor 120 may make the voltage data and the capacity data differentiable in the target section.

According to an embodiment, the processor 120 may interpolate the converted capacity data and voltage data to calculate differential capacity data. The processor 120 may interpolate the converted capacity data and voltage data to convert the voltage data and the capacity data to have a monotonically increasing or monotonically decreasing form, and then calculate differential capacity data.

In one embodiment, the processor 120 may interpolate the converted capacity data and voltage data using a piecewise cubic Hermite interpolating polynomial (PCHIP) method.

The PCHIP method may maintain the form of raw data and increase the monotonicity of data, and thus has an advantage of less distortion of interpolated data in comparison to other monotonic methods such as a smooth spline method. In particular, data, such as field data, which is likely to generate noise or abnormal data, may have characteristics that are not smooth in comparison to experimental data, and in this case, when the PCHIP method is applied, it is possible to reduce overshooting or oscillation of data.

In one embodiment, the processor 120 may set a specified voltage interval to apply the PCHIP method. Since the differential capacity data represents a change in capacity per unit voltage (or a change in voltage per unit capacity), the processor 120 may set the specified voltage interval for consistent analysis of the data to apply the PCHIP method. The processor 120 may set an appropriate voltage interval so that the oscillation of data is reduced and the characteristics are prevented from becoming unclear. For example, the specified voltage interval may be set to 5 mV.

In this case, the processor 120 may interpolate values of the capacity data corresponding to the voltage interval for each specified voltage interval, thereby making the form of the voltage data and the capacity data monotonic.

The processor 120 may calculate differential capacity data from the capacity data and voltage data interpolated by the PCHIP method. The differential capacity data may be data (dqdv) obtained by differentiating the capacity into the voltage or data (dvdq) obtained by differentiating the voltage into the capacity.

According to an embodiment, the processor 120 may perform Gaussian filtering on the differential capacity data with a preset window size to smooth the differential capacity data. The processor 120 may smooth the differential capacity data through the Gaussian filtering to more accurately extract indicators from the differential capacity data.

The processor 120 can reduce noise of data and increase tendency through the Gaussian filtering and reduce oscillation of data. In this case, the processor 120 may set a window size that satisfies an appropriate trade-off so that the oscillation of data is reduced and the characteristics are prevented from becoming unclear.

The processor 120 may extract at least one feature for diagnosing the battery based on the value of the differential capacity data in at least one voltage band set based on the characteristics of at least one of the battery and the electronic device.

That is, since the voltage band in which the characteristics for diagnosing the battery is exhibited may vary depending on the type of the battery or the like, the processor 120 may identify at least one voltage band set based on the characteristics of at least one of the battery and the electronic device in order to extract features.

In one embodiment, when an inflection point of the differential capacity data is present in each voltage band, the processor 120 may extract at least one of the minimum value and the maximum value of the differential capacity data in the voltage band as a feature.

For example, the processor 120 may identify maximum and minimum values of the differential capacity data in all voltage bands and identify local maximum and minimum values in the corresponding voltage band. When the maximum or minimum value is included in a region between the identified local maximum and minimum values, the processor 120 may extract at least one of the minimum and maximum values as a feature.

According to an embodiment, the processor 120 may perform diagnosis on the battery based on the value of the differential capacity data corresponding to the feature. Since a feature value (a value of the differential capacity data, the corresponding voltage, or the like) of the feature extracted as described above acts as an indicator reflecting the characteristics (e.g., the degree of deterioration) of the battery, the processor 120 may perform diagnosis on the battery based on the value of the differential capacity data corresponding to the feature, that is, the feature value.

For example, the processor 120 may directly perform diagnosis on the battery by analyzing a relationship between the feature value corresponding to the feature and diagnosis items of the battery. In another example, the processor 120 may analyze a change in feature value corresponding to the feature to perform the state change or state diagnosis of the battery. For example, when the battery is provided in the vehicle, the processor 120 may monitor a change in feature value according to a driving distance of the vehicle and diagnose the degree of deterioration of the battery according to the change in feature value.

According to an embodiment, the processor 120 may build a database by matching the characteristics corresponding to the extracted features with the characteristics related to the battery. For example, the characteristics corresponding to the features may include the value of the differential capacity data in which the feature is exhibited, the voltage band in which the feature is exhibited, and the like, and the characteristics related to the battery may include a charging start time, a charging end time, a charging start state of charge (SoC), a charging end SoC, the characteristics of the electronic device having the battery, for example, the driving distance of the vehicle, and the like.

The processor 120 may extract features from the field data and build the features as a database to use the built database for the subsequent battery feature extraction and diagnosis.

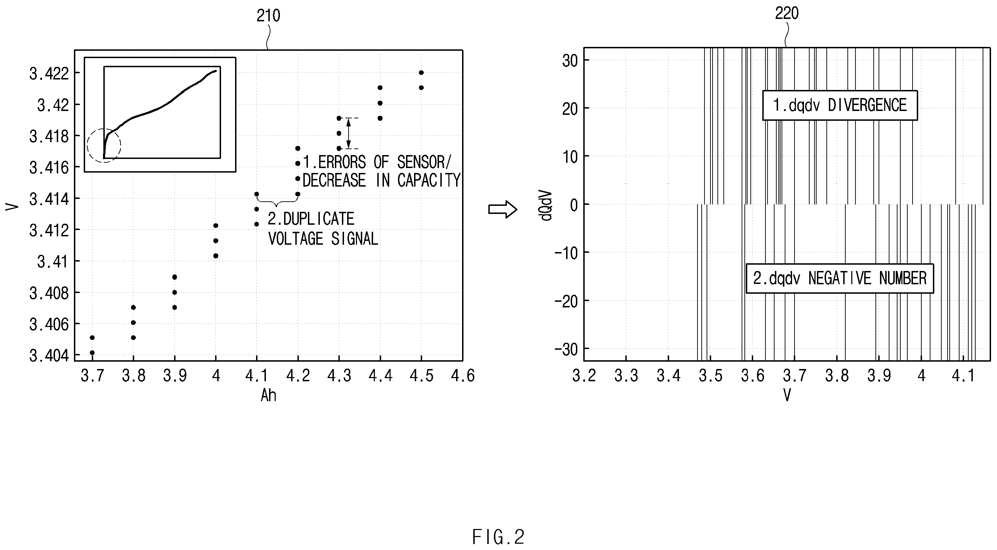

FIG. 2 is a view illustrating an example of battery data and differential data according to one embodiment disclosed herein.

A graph 210 of FIG. 2 shows an example of the voltage data and capacity data acquired from the interface unit 110. Referring to the graph 210, noise or distorted data (such as a decrease in capacity during charging) due to errors in a sensor itself, duplicate voltage signals, or the like may appear in the field data of the battery acquired from the interface unit 110.

The graph 220 shows an example in which differential capacity data is calculated from the data of the graph 210. Referring to the graph 220, when differential capacity data is calculated without preprocessing the duplicate voltage signals of the field data, the values of the differential capacity data may diverge as in the graph 220, making differentiation impossible, or data values may be distorted as a negative number.

Accordingly, the processor 120 may preprocess the battery data acquired from the interface unit 110 to prevent distortion of the differential capacity data as in the graph 220.

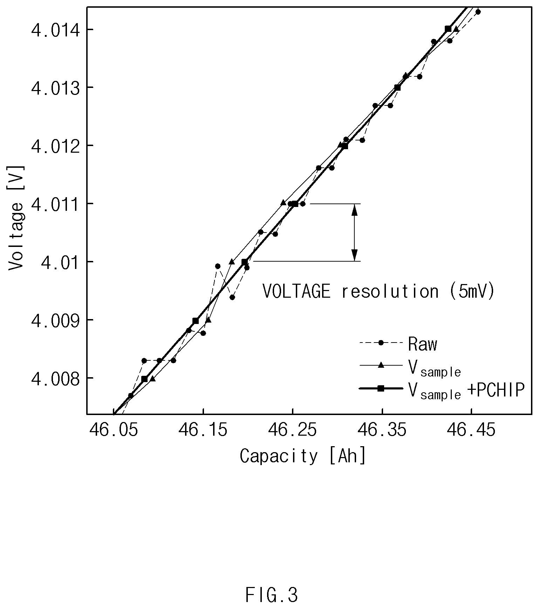

FIG. 3 is a view illustrating a preprocessing process of the battery data according to one embodiment disclosed herein.

Referring to FIG. 3, a graph showing the result of performing preprocessing on battery voltage data through sampling and PCHIP is illustrated. As illustrated in FIG. 3, raw data of a voltage includes duplicate signals and noise, but the voltage data may be converted to have a monotonically increasing form through the sampling process and the PCHIP interpolation method of the processor 120. Here, it can be understood that the sampling process is a process of removing duplicate voltage signals.

In FIG. 3, it can be confirmed that the graph shows the monotonically increasing form that increases smoothly without noise as a result of applying the PCHIP interpolation method to the sampled data, that is, the sampled data from which the duplicate voltage signals have been removed, at a specified voltage interval (voltage resolution).

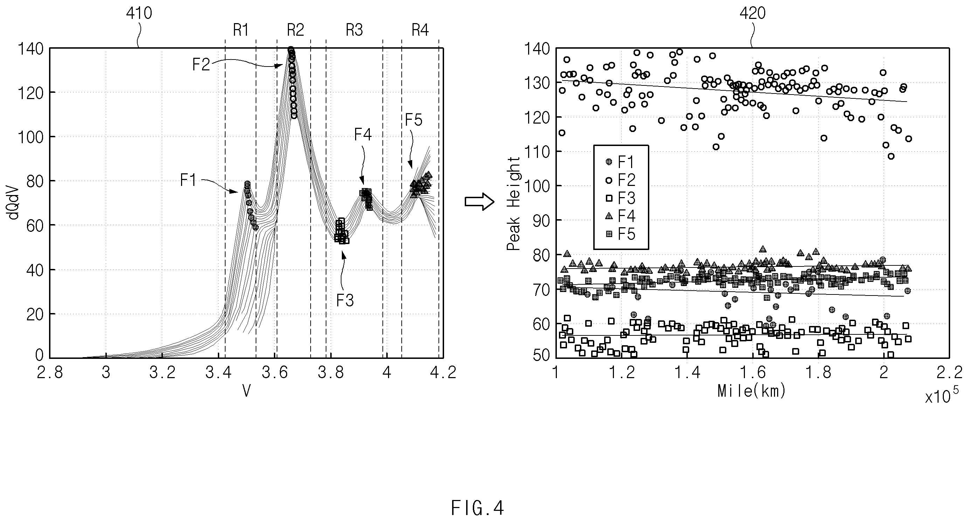

FIG. 4 is a view illustrating an example of feature extraction according to one embodiment disclosed herein.

Referring to FIG. 4, the processor 120 may extract features based on values of differential capacity data in each voltage band and analyze feature values.

A graph 410 of FIG. 4 shows four voltage bands R1 to R4 and features F1 to F5 extracted from the voltage bands. Each voltage band may be set based on the characteristics of at least one of the battery and the electronic device. In one embodiment, the voltage band may be set based on the type of the battery, the type of the electronic device having the battery (e.g., the type of the vehicle when the electronic device is a vehicle), or the like.

The processor 120 may identify whether an inflection point of the differential capacity data is present in each voltage band. When the inflection point of the differential capacity data is present in each voltage band, the processor 120 may extract at least one of the minimum value and the maximum value of the differential capacity data in the voltage band as a feature. For example, when the graph shown by the differential capacity data in a specific voltage band is convex upward, the processor 120 may extract the maximum value of the differential capacity data as a feature.

Referring to the graph 410 of FIG. 4, the processor 120 may identify the inflection point of the differential capacity data in voltage band R1 and extract a data value at the inflection point, that is, the maximum value of the differential capacity data in band R1, as a feature F1 of the battery. In this way, the processor 120 may calculate the features F1 to F5 for diagnosing the battery in each of the bands R1 to R4.

The processor 120 may perform diagnosis on the battery based on the value of the differential capacity data corresponding to the extracted feature. For example, as exemplarily shown in the graph 420 of FIG. 4, the processor 120 may analyze a relationship between the value of the differential capacity data corresponding to a feature of a target battery and a driving distance of the vehicle. The processor 120 may analyze a relationship between the feature value through analysis, the driving distance, and the degree of deterioration of the battery and diagnose the degree of deterioration of the battery from the feature value. For example, it can be confirmed that a value (peak) of the differential capacity data of the feature value tends to decrease as the driving distance increases, that is, as the degree of degradation of the battery increases.

In addition, the processor 120 may further analyze main features that may be used for diagnosis according to the diagnosis items of the battery. For example, referring to a graph 420 of FIG. 4, it can be confirmed that a change in feature value according to the driving distance is prominent in the feature F1. In this case, the processor 120 may use the feature value of the feature F1 as the main analysis target rather than the other features F2 to F5 when diagnosing deterioration of the battery.

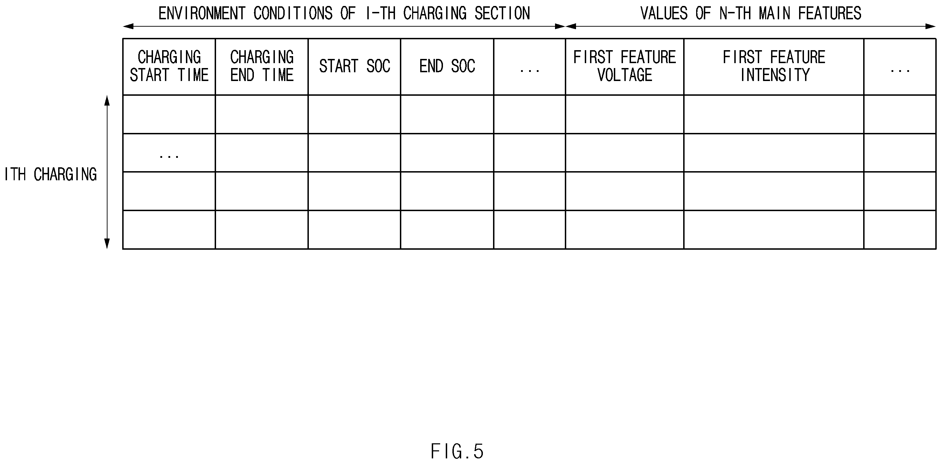

FIG. 5 is a view illustrating an example of information stored in a database according to one embodiment disclosed herein.

Referring to FIG. 5, the processor 120 may build a database by matching the characteristics corresponding to the extracted features with the characteristics of the battery. For example, as illustrated in FIG. 5, the processor 120 may match the characteristics of the extracted features with the characteristics of the battery for each charging.

For example, the processor 120 may match information such as a charging start time, a charging end time, a start SOC, and an end SOC related to the data used during feature extraction with feature values such as voltages and intensities of extracted features and store the result of the matching.

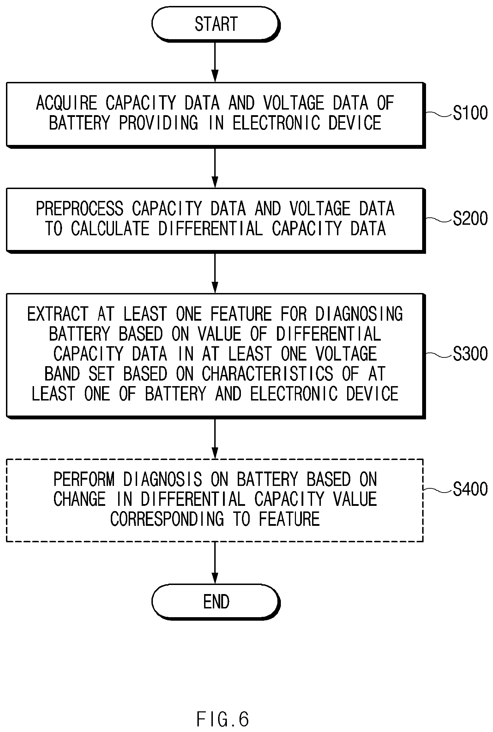

FIG. 6 is a flowchart for describing the data analysis method according to one embodiment disclosed herein. The embodiment illustrated in FIG. 6 is only one embodiment, the order of operations according to various embodiments of the present disclosure may differ from that illustrated in FIG. 6, and some operations illustrated in FIG. 6 may be omitted, the order between the operations may be changed, or the operations may be combined.

Referring to FIG. 6, the data analysis method may include acquiring capacity and voltage data of a battery provided in an electronic device (S100), preprocessing the capacity data and the voltage data to calculate differential capacity data (S200), and extracting at least feature for diagnosing the battery based on a value of the differential capacity data in at least one voltage band set based on characteristics of at least one of the battery and an electronic device (S300), and performing diagnosis on the battery based on a change in differential capacity value corresponding to the feature (S400).

In operation S100, the interface unit 110 may acquire the capacity and voltage data of the battery provided in the electronic device. For example, the interface unit 110 may acquire time series data on capacity and voltage during a charging process of the battery.

In operation S200, one or more processors 120 may preprocess the capacity data and the voltage data to calculate differential capacity data.

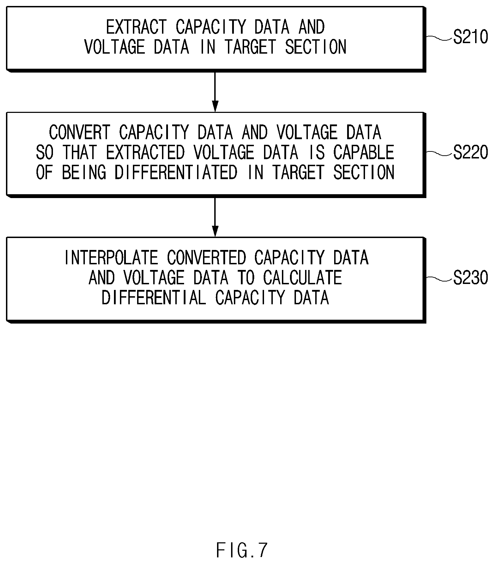

Referring to FIG. 7, a process of calculating differential capacity data by one or more processors 120 according to one embodiment may include extracting capacity data and voltage data in a target section (S210), converting the capacity data and the voltage data so that the extracted voltage data may be differentiated in the target section (S220), and interpolate the converted capacity data and voltage data to calculate differential capacity data (S230).

In operation S210, the one or more processors 120 may extract the capacity data and the voltage data in the target section. In one embodiment, the one or more processors 120 may define a slow charging section during a charging process of the battery as a target section and extract capacity data and voltage data corresponding to the slow charging section.

In operation S220, the one or more processors 120 may convert the capacity data and the voltage data so that the extracted voltage data may be differentiated in the target section. In one embodiment, the one or more processors 120 may classify capacity data having the same voltage value among the extracted voltage data, calculate an average value of the multiple capacity data having the same voltage value, and convert the calculated average value into a capacity value corresponding to the voltage value.

In operation S230, the one or more processors 120 may interpolate the converted capacity data and voltage data to calculate differential capacity data. In one embodiment, the one or more processors 120 may interpolate the converted capacity data and voltage data using the PCHIP method. The one or more processors 120 may differentiate the interpolated voltage data and capacity data to calculate differential capacity data.

In operation S300, the one or more processors 120 may extract at least one feature for diagnosing the battery based on the value of the differential capacity data in at least one voltage band set based on the characteristics of at least one of the battery and the electronic device. In one embodiment, when an inflection point of the differential capacity data is present in each voltage band, the one or more processors 120 may extract at least one of the minimum value and the maximum value of the differential capacity data in the voltage band as a feature.

In operation S400, the one or more processors 120 may perform diagnosis on the battery based on the differential capacity value corresponding to the feature. For example, the one or more processors 120 may analyze the differential capacity value corresponding to the feature to perform diagnosis on the battery.

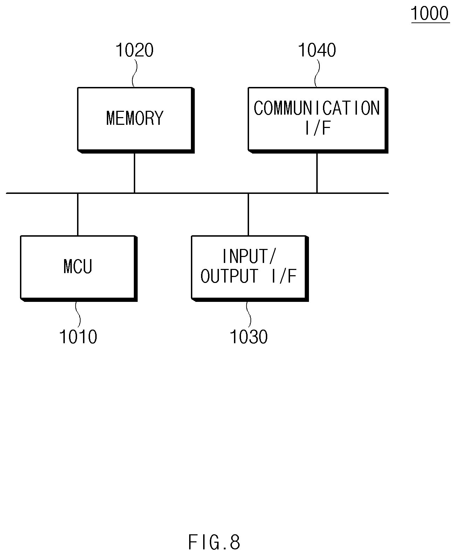

FIG. 8 is a block diagram showing a hardware configuration of a computing system for performing a method of operating a data analysis device according to one embodiment disclosed herein.

Referring to FIG. 8, a computing system 1000 according to one embodiment disclosed in this document may include a micro controller unit (MCU) 1010, a memory 1020, an input/output I/F 1030, and a communication I/F 1040.

The MCU 1010 may be a processor configured to execute various programs stored in the memory 1020, process various pieces of information including battery data through these programs, and perform functions of the processor included in the above-described data management device illustrated in FIG. 1.

The memory 1020 may store various programs for performing the functions of the data management device. In addition, the memory 1020 may store various pieces of information including battery data (voltage data, capacity data, and the like), differential capacity data, and the like and include a built database.

The memory 1020 may be provided as a plurality of memories as needed. The memory 1020 may be a volatile memory or a non-volatile memory. As the memory 1020 of the volatile memory, a RAM, a DRAM, a SRAM, etc. can be used. As the memory 1020 of the non-volatile memory, a ROM, a PROM, an EAROM, an EPROM, an EEPROM, a flash memory, etc. can be used. Examples of the above-listed memories 1020 are merely illustrative and are not limited to these examples.

The input/output I/F 1030 may be an interface for connecting an input device (not shown), such as a keyboard, a mouse, or a touch panel, and an output device, such as a display (not shown) with the MCU 1010 and allowing the input and output devices and the MCU 4610 to transmit and receive data.

The communication I/F 1040 is a component capable of transmitting and receiving various data to and from the server and may be various devices capable of supporting wired or wireless communication. For example, the data management device may transmit and receive various pieces of information including battery data and the like from a separately provided external server or the like through the communication I/F 1040.

As described above, the computer program according to one embodiment disclosed herein may be implemented as a module for performing the functions shown in FIG. 1, for example, by being recorded in the memory 1020 and processed by the MCU 1010.

As described above, although all the components constituting the embodiments disclosed herein were described as being coupled or operated by being coupled, the embodiments disclosed herein are not necessarily limited to these embodiments. In other words, one or more of all the components may be operated by being selectively coupled without departing from the scope of the purpose of the embodiments disclosed herein.

In addition, the terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A data analysis device comprising:
an interface unit configured to acquire capacity data and voltage data of a battery provided in an electronic device; and
one or more processors configured to:
preprocess the capacity data and the voltage data to calculate differential capacity data; and
extract at least one feature for diagnosing the battery based on a value of the differential capacity data in at least one voltage band set based on characteristics of at least one of the battery and the electronic device.

2. The data analysis device of claim 1, wherein the one or more processors are configured to:
extract the capacity data and the voltage data in a target section;
convert the capacity data and the voltage data so that the extracted voltage data is capable of being differentiated in the target section; and
interpolate the converted capacity data and voltage data to calculate the differential capacity data.

3. The data analysis device of claim 2, wherein the one or more processors are configured to identify the target section corresponding to a slow charging section during charging of the battery to extract the capacity data and the voltage data.

4. The data analysis device of claim 2, wherein the one or more processors are configured to:
classify multiple capacity data having the same voltage value among the extracted voltage data; and
calculate an average value of the multiple capacity data having the same voltage value and convert the average value into a capacity value corresponding to the voltage value.

5. The data analysis device of claim 2, wherein the one or more processors are configured to interpolate the converted capacity data and voltage data using a piecewise cubic Hermite interpolating polynomial (PCHIP) method to convert a voltage of the battery to monotonically increase or monotonically decrease.

6. The data analysis device of claim 1, wherein the one or more processors are configured to perform Gaussian filtering on the differential capacity data with a preset window size to smooth the differential capacity data.

7. The data analysis device of claim 1, wherein, when an inflection point of the differential capacity data is present in each voltage band, the one or more processors are configured to extract at least one of a minimum value and a maximum value of the differential capacity data in the voltage band as the feature.

8. The data analysis device of claim 1, wherein the one or more processors are configured to perform diagnosis on the battery based on a value of differential capacity data corresponding to the feature.

9. The data analysis device of claim 1, wherein the one or more processors are configured to match characteristics corresponding the extracted features with characteristics of the battery to build a database.

10. A data analysis method comprising:
acquiring capacity data and voltage data of a battery provided in an electronic device;
preprocessing the capacity data and the voltage data to calculate differential capacity data; and
extracting at least one feature for diagnosing the battery based on a value of the differential capacity data in at least one voltage band set based on characteristics of at least one of the battery and the electronic device.

11. The data analysis method of claim 10, wherein the calculating of the differential capacity data includes:
extracting the capacity data and the voltage data in a target section;
converting the capacity data and the voltage data so that the extracted voltage data is capable of being differentiated in the target section; and
interpolating the converted capacity data and voltage data to calculate the differential capacity data.

12. The data analysis method of claim 10, wherein, when an inflection point of the differential capacity data is present in each voltage band, the extracting of the at least one feature includes extracting at least one of a minimum value and a maximum value of the differential capacity data as the feature.

13. The data analysis method of claim 10, further comprising performing diagnosis on the battery based on a change in differential capacity value corresponding to the feat ure.
